(19) Europäisches Patentamt
European Patent Office
Office européen des brevets

(11) **EP 1 604 448 B1**

(12) **EUROPÄISCHE PATENTSCHRIFT**

(45) Veröffentlichungstag und Bekanntmachung des Hinweises auf die Patenterteilung:
**18.07.2007 Patentblatt 2007/29**

(21) Anmeldenummer: **04711345.1**

(22) Anmeldetag: **16.02.2004**

(51) Int Cl.:
**H02N 2/06** ^(2006.01)

(86) Internationale Anmeldenummer:
**PCT/EP2004/001438**

(87) Internationale Veröffentlichungsnummer:
**WO 2004/082117 (23.09.2004 Gazette 2004/39)**

(54) **VERFAHREN UND VORRICHTUNG ZUR REDUKTION VON SCHALLEMISSIONEN UND HOCHFREQUENTEN SCHWINGUNGEN EINES PIEZOELEKTRISCHEN AKTORS**

METHOD AND DEVICE FOR REDUCING NOISE EMISSIONS AND HIGH-FREQUENCY VIBRATIONS OF A PIEZOELECTRIC ACTUATOR

PROCEDE ET DISPOSITIF DE REDUCTION DES EMISSIONS DE BRUIT ET DES OSCILLATIONS A HAUTE FREQUENCE D'UN ACTIONNEUR PIEZO-ELECTRIQUE

(84) Benannte Vertragsstaaten:
**DE FR GB IT**

(30) Priorität: **14.03.2003 DE 10311350**

(43) Veröffentlichungstag der Anmeldung:
**14.12.2005 Patentblatt 2005/50**

(73) Patentinhaber: **SIEMENS AKTIENGESELLSCHAFT 80333 München (DE)**

(72) Erfinder:
• **D'OUVENOU, Lorand 93170 Bernhardswald (DE)**
• **HIRN, Rainer 93073 Neutraubling (DE)**
• **HOFFMANN, Christian 93057 Regensburg (DE)**
• **LINGL, Wolfgang 95508 Kulmain (DE)**
• **ÖSTREICHER, Wolfgang 93047 Regensburg (DE)**

(56) Entgegenhaltungen:
WO-A-01/33061          DE-A- 10 213 875
DE-A- 19 931 235       DE-A- 19 958 262
DE-C- 10 143 502

## EP 1 604 448 B1

**Beschreibung**

Die Erfindung betrifft ein Verfahren und eine Vorrichtung zur Reduktion von Schallemissionen und hochfrequenten Schwingungen eines piezoelektrischen Aktors, wie er beispielsweise bei Bremsen, Dosiereinrichtungen, optischen Spiegeln und Linsengeräten, piezoelektrisch angetriebenen Aktoren beispielsweise zum Steuern von Injektoren von Einspritzanlagen oder Ventilverstellungen eingesetzt wird.

Speziell bei piezoelektrisch Aktoren treten aufgrund von hohen Schaltgeschwindigkeiten und von hohen inneren Kräfte bei deren Betrieb oft starke Vibrationen auf. Diese Vibrationen sind spektral sehr breitbandig und erzeugen ein hohes Maß an Körperschall. Dieser Körperschall wird beispielsweise bei einem Einspritzsystem eines Verbrennungsmotors vom gesamten Motorblock weitergeleitet und von einem Benutzer als metallisches, unangenehmes rhythmisches Geräusch wahrgenommen.

Da Verbrennungsmotoren, insbesondere Dieselmotoren, aufgrund der so genannten weichen Brennverfahren, die durch Mehrfacheinspritzung und/oder Aufladung erreicht wird, immer leiser werden, wird es als störend empfunden, dass das Geräusch der piezoelektrisch angetriebenen Injektoren aus dem Gesamtgeräusch des Verbrennungsmotors störend herauszuhören ist.

Aus der Offenlegungsschrift DE 199 46 965 A1 ist ein geräuschgedämpfter piezoelektrischer Antrieb bekannt. Bei diesem piezoelektrischen Antrieb ist das Piezoelement von einem Gehäuse umgeben, das wenigstens teilweise aus einem Werkstoff mit schwingungsdämpfenden Eigenschaften gefertigt ist. Bei diesem bekannten Antrieb wird der Körperschall dadurch reduziert, dass er durch eine geeignete mechanische Entkopplung und Isolation an einer Weiterleitung und Ausbreitung gehindert wird. Hier muss jedoch konstruktiv in das Verbindung zwischen Aktor und angetriebenem Element eingegriffen werden.

Weiter existieren Verfahren, die über Sensoren, die Vibrationen des Gesamtsystems erfassen und durch eine adaptive Regelung der Vibration entgegenwirken. Aufgrund der zusätzlich benötigten Sensoren und der dazugehörigen Steuer- und Regelelektronik sind diese Systeme aufwendig und teuer.

Weiter ist eine Vorrichtung zum Ansteuern eines kapazitiven Stellglieds bekannt (DE 101 43 502 C1), bei der mittels eines nichtlinearen Aktormodells die vom kapazitiven Stellglied auf ein Einspritzventil bei einer Haupteinspritzung ausgeübte Kraft und daraus der Gradiert des Kraftabfalls aus dem Kraftmaximum ermittelt wird. Weiter wird ein Grenzwert bestimmt, mit dem der bei einer Vor- oder Nacheinspritzung ermittelte Gradient verglichen wird und entsprechend dem Vergleichsergebnis die Signalparameter für die nächste Vor- oder Nacheinspritzung korrigiert werden.

Bei einer bekannten Vorrichtung zum Laden eines kapazitiven Stellglied (DE 199 31 235 A1) wird mit unterschiedlichen Lade- und Entladezeiten geladen bzw. entladen. Zur Verkürzung der Ladezeit wird dort während des Ladevorgangs eine für eine maximale Ladezeit gemessene Kapazität eines Umladekondensators verringert.

Ferner ist eine Vorrichtung zum Aufladen eines kapazitiven Stellglieds bekannt (DE 199 58 262 A1), bei der die Aufladung gemäß einer Referenzkurve in mehreren Schritten durchgeführt wird, wobei nach jedem Schritt die am Stellglied anliegende Spannung gemessen wird und mit der entsprechenden Spannung der Referenzkurve verglichen wird.

Bei einer bekannten Kontrolleinheit für ein kapazitves Stellglied (WO 01/33061 A1) wird das kapazitive Stellglied von einer als Fly-Back-Konverter mit einem Transformator ausgebildeten Endstufe angesteuert, wobei eine Lade- und/ oder Entladevorrichtung mit einem Schalttransistor vorgesehen ist, die mit einem pulsweiten- modulierten Signal in einen leitenden Zustand geschaltet wird.

Aufgabe der Erfindung ist es, ein Verfahren zur Reduktion von Schallemissionen und hochfrequenten Schwingungen eines piezoelektrischen Aktors zu schaffen. Darüber hinaus soll eine Vorrichtung zur Umsetzung des erfindungsgemäßen Verfahrens angegeben werden.

Diese Aufgabe wird durch ein Verfahren mit den Merkmalen des Anspruchs 1 und durch eine Vorrichtung mit den Merkmalen des Anspruchs 4 gelöst.

Erfindungsgemäß erzeugt ein Signalgenerator eine vorbestimmte Signalform, die wiederum einer Ansteuereinheit zugeführt wird. Die Ansteuereinheit erzeugt einen Ansteuerstrom, der im Verlauf der durch den Signalgenerator erzeugten Signalform entspricht. Über die Ansteuereinheit wird der piezoelektrische Aktor durch den Ansteuerstrom geladen oder entladen. Dieser Ansteuerstrom ist so ausgebildet, dass in einem Frequenzgang des Ansteuerstroms 99% der Amplitudenanteile unterhalb einer vorgegebenen Grenzfrequenz liegen. Der Amplitudenbetrag des Ansteuerstroms in Abhängigkeit von der Frequenz weist bei den Resonanzfrequenzen des piezoelektrischen Aktors Minima auf.

Die erfindungsgemäße Vorrichtung zum Ansteuern eines piezoelektrischen Aktors weist einen Signalgenerator und eine Ansteuereinheit auf. Auch hier ist der den piezoelektrischen Aktor ansteuernde Strom so ausgebildet, dass in seinem Frequenzgang 99% der Amplitudenanteile unterhalb einer vorgegebenen Grenzfrequenz liegen.

Der Amplitudenbetrag des Ansteuerstroms in Abhängigkeit von der Frequenz weist bei den Resonanzfrequenzen des piezoelektrischen Aktors Minima auf.

Bei dem erfindungsgemäßen Verfahren und der Vorrichtung wird ein piezoelektrischer Aktor so angesteuert, dass auf einfache Weise Schallemissionen und hochfrequente Schwingungen vermieden werden. Ein weiterer Vorteil des Verfahrens und der Vorrichtung liegt darin, dass kein mechanischer Eingriff am piezoelektrischen Aktor erforderlich ist.

Auf diese Weise wird der piezoelektrische Aktor unterhalb seiner Resonanzfrequenz betrieben und so ein Erreichen der Endlage ohne Überschwingen ermöglicht.

Das Verfahren bietet weiter den Vorteil, dass keine mechanischen Eingriffe am System, in dem der Aktor eingesetzt wird, erforderlich sind.

Vorteilhafte Ausgestaltungen der Erfindung sind in den Unteransprüchen beschrieben.

Die Grenzfrequenz kann zwischen 5000 Hz und 10000 Hz, vorzugsweise bei etwa 7500 Hz liegen. Dies hat den Vorteil, dass der piezoelektrische Aktor unterhalb seiner Resonanzfrequenz betrieben wird und so ein Erreichen seiner Endlage ohne Überschwingen ermöglicht.

Zusätzlich zum erfindungsgemäßen Verfahren und der Vorrichtung können auch konstruktive Maßnahmen zur Körperschalldämmung eingesetzt werden. Hierdurch kann eine weitere Reduktion der Schallemissionen und Schwingungen erzielt werden.

Ein Ausführungsbeispiel des erfindungsgemäßen Verfahrens und der Vorrichtung werden im Folgenden anhand der schematischen Zeichnungen näher erläutert. Es zeigen:

Figur 1    ein Blockschaltbild eines Ausführungsbeispiels einer erfindungsgemäßen Schaltungsanordnung,

Figur 2    eine Darstellung eines erfindungemäßen Steuerstroms als Funktion der Zeit,

Figur 3    eine Darstellung des Steuerstroms im Zeit- und Frequenzbereich, und

Figur 4    eine Darstellung mehrer möglicher Pulsformen des Steuerstroms im Frequenzbereich.

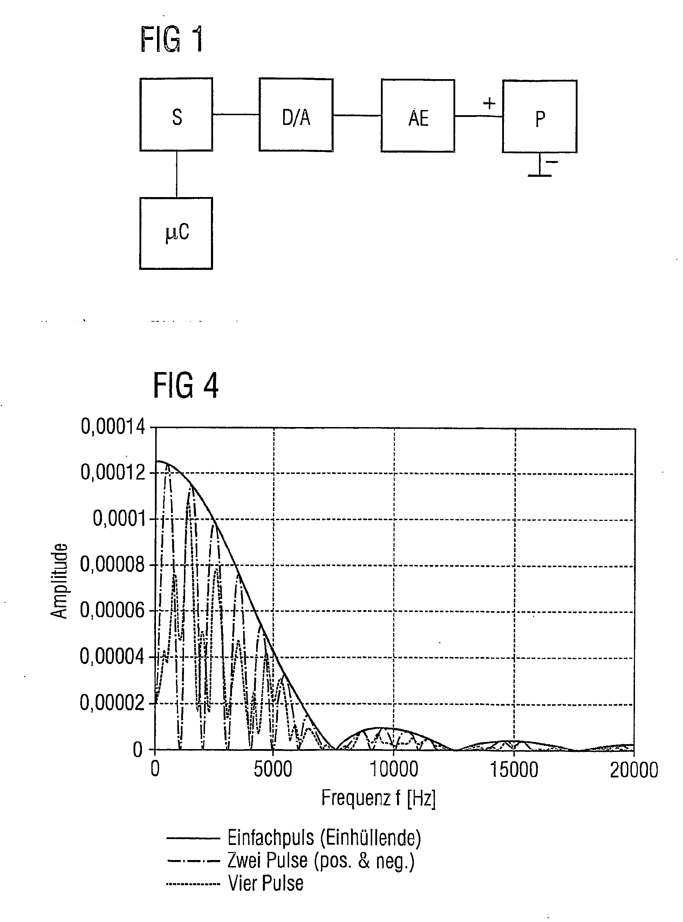

Figur 1 zeigt ein Blockschaltbild eines ersten Ausführungsbeispiel einer Schaltungsanordnung, die hier zur Ansteuerung eines piezoelektrischen Aktors P dient. Dem piezoelektrischen Aktor P sind eine Reihe von schematisch dargestellten Baugruppen vorgeschaltet. Ein Mikrocontroller µC steuert einen Speicher S an, in dem die Form eines Ansteuerstromes $I_{st}$ in digitaler Form abgelegt ist. Dieses Signal wird einem Digital-Analog-Wandler D/A zugeführt, der wiederum das gewandelte analoge Stromsignal einer Ansteuereinheit AE zuführt. Der Ausgang der Ansteuereinheit AE ist hier mit dem positiven Anschluss des piezoelektrischen Aktors P verbunden. Der negative Anschluss des piezoelektrischen Aktors P ist mit Masse verbunden. Die Ansteuereinheit AE steuert den piezoelektrischen Aktor P mit dem Steuerstrom $I_{st}$ an.

Als Ansteuereinheit AE kann ein Spannungsverstärker oder ein Linearverstärker, insbesondere ein Strom- oder Ladungsverstärker, verwendet werden.

Üblicherweise werden zum Laden und Entladen eines piezoelektrischen Aktors P sinusförmige Stromformen verwendet. Hierbei wird der piezoelektrische Aktor P mit einer positiven Sinushalbwelle geladen und im Anschluss daran mit einer negativen Sinushalbwelle wieder entladen.

Das Resonanzverhalten des piezoelektrischen Aktors P und/oder des Systems, in dem der piezoelektrische Aktor P eingesetzt wird, wird analysiert und so eine oder mehrere Resonanzfrequenzen $f_R$ des Systems identifiziert. Der so gewonnene Amplitudengang wird von einem Bildbereich in einen Zeitbereich transformiert und so auf die Stromform geschlossen, die Schallemissionen und hochfrequente Schwingungen des Aktors P reduziert.

Das System umfasst beispielsweise bei einer Brennkraftmaschine einen Injektor, zu dessen Ansteuerung der Aktor P dient, sowie die Brennkraftmaschine selbst und die damit verbundenen Anbauteile.

Eine Transformationsgleichung definiert die Zuordnung eines Eingangssignals im Zeitbereich zu einem Bildsignal im Bildbereich.

Eine in der Nachrichtentechnik häufig verwendete Transformation ist beispielsweise die Fourier-Transformation. Durch die Fourier-Transformationsgleichung

$$S(f) = \int\limits_{-\infty}^{\infty} s(t)\, e^{-j2\pi f t}\, dt$$

mit

t - Zeit
f - Frequenz

wird der Amplitudenfaktor (Frequenzgang) S(f) berechnet, d.h. das Signal s(t) im Zeitbereich wird in ein Signal S(f) im Bildbereich, hier dem Frequenzbereich transformiert. Der Amplitudenfaktor S(f) hat die Dimension "Amplitude mal Zeit" oder gleichbedeutend "Amplitude geteilt durch Frequenz". Daher wird auch die Fourier-Transformierte eines Signals als Amplitudendichtespektrum bezeichnet. Der Amplitudengang ist der Betrag des Frequenzganges in Abhängigkeit von der Frequenz.

Für ein im Zeitbereich endliches Ansteuersignal ist das entsprechende Spektrum im Frequenzbereich unendlich.

Um die hochfrequenten Anteile des Steuersignals im Frequenzbereich und damit die durch die Ansteuerung des piezoelektrischen Aktors P entstehenden hochfrequenten Schallemissionen und Vibrationen zu reduzieren, muss im Idealfall ein im Frequenzbereich bandbegrenztes Signal verwendet werden. Da dieser Idealfall jedoch eine im Zeitbereich unbegrenzte Funktion zur Folge hat, wird zur Ansteuerung eine Näherungsfunktion verwendet.

Eine solche Näherungsfunktion zeichnet sich dadurch aus, dass im Frequenzbereich keine Bandbegrenzung stattfindet, jedoch diese Näherungsfunktion ab einer bestimmten Grenzfrequenz fg eine deutliche Reduktion der spektralen Komponenten im Vergleich zu der herkömmlichen sinusförmigen Halbwelle aufweist. Die Reduktion dieser Oberwellen hat zur Folge, dass die Schallemissionen und die hochfrequenten Schwingungen am piezoelektrischen Aktor P reduziert werden und somit das vom Benutzer als störend empfundene Geräusch reduziert wird.

Die ideale Form des Ansteuerstromes $I_{ST}$ im Frequenzbereich entspricht einem Rechteck. Da die zugehörige Stromform im Zeitbereich in der Praxis nicht realisierbar ist, gelangt man zu einer Näherungsfunktion, der sogenannten Si-Funktion:

$$Si(x) = \frac{\sin x}{x} \ .$$

Da diese Si-Funktion aber negative Anteile enthält, die zu negativen Spannungen am piezoelektrischen Aktor P und somit zu dessen Zerstörung führen können, wird zum Aufladen und Entladen des piezoelektrischen Aktors P vorzugsweise das Quadrat dieser Si-Funktion ($Si^2$) verwendet. Die $Si^2$-Funktion weist im Frequenzbereich bis zu einer Grenzfrequenz $f_g$ ein linear fallendes Spektrum ähnlich einer Dreiecksfunktion auf. Ab dieser Grenzfrequenz $f_g$ ist das Frequenzspektrum Null.

Die Funktion wird im Zeitbereich durch die folgende Funktion beschrieben:

$$s(t) = \left( \frac{\sin(2 \cdot \pi \cdot f_0 \cdot t)}{(2 \cdot \pi \cdot f_0 \cdot t)} \right)^2 \cdot \left[ \sigma(t + T_i) - \sigma(t - T_i) \right]$$

mit

$f_0$ - Grundfrequenz beispielsweise 4000Hz,
$2\,T_i$ - Pulsdauer $t_i$, und
$[\sigma(t + T_i) - \sigma(t - Ti)]$ - Rechteckfunktion von $-T_i$ bis $+T_i$.

Das Frequenzspektrum ergibt sich durch eine Faltung der Zeitfunktion mit einer Tastfunktion (Rechtecksignal):

$$\underline{S}(f) = \left( 1 - |f| \cdot T_i \right) \cdot \left[ \sigma(f + \frac{1}{T_i}) - \sigma(f - \frac{1}{T_i}) \right]$$

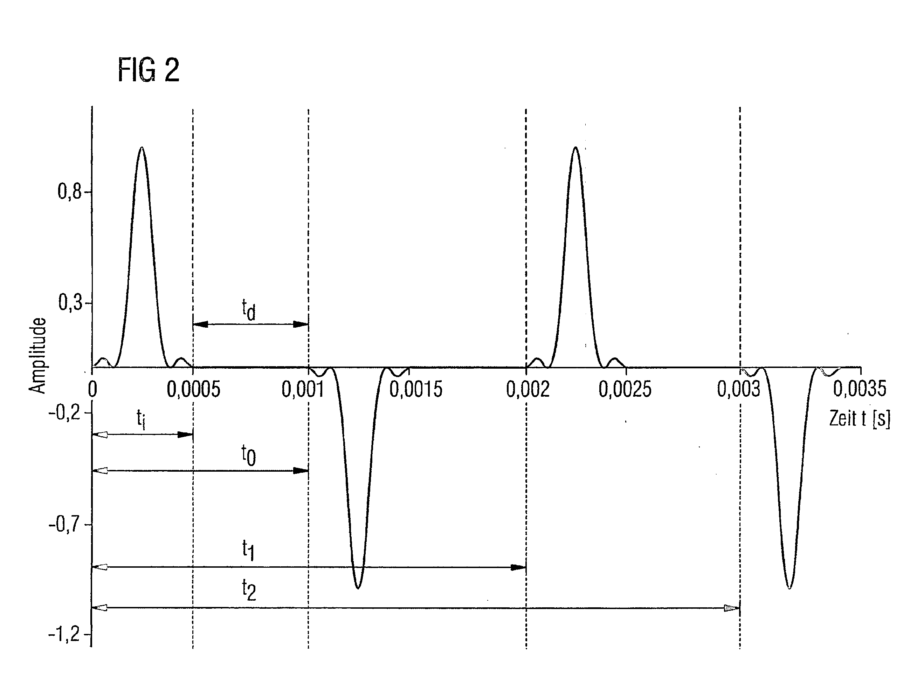

Figur 2 zeigt den Verlauf des Steuerstroms $I_{ST}$ des piezoelektrischen Aktors P in Abhängigkeit von der Zeit t.

Hierbei entspricht die Zeitdauer eines Pulses der Pulsdauer (Bestromungszeit) $t_i$ und der Abstand zwischen einem Lade- und einem Entladepuls der Zeitdauer $t_d$, wobei der Entladepuls zum Zeitpunkt $t_0$ beginnt. Ein zweiter hier dargestellter Ladepuls beginnt zum Zeitpunkt $t_1$, wobei der zweite Entladepuls zum Zeitpunkt $t_2$ beginnt.

Der Beginn und die Dauer des Strompulses sind hier so gewählt, dass der Strom beim zweiten Nullpunkt vor

dem Maximum der Si$^2$-Funktion beginnt (t=0) und beim zweiten Nullpunkt nach dem Maximum endet (t=0,5ms). Somit kann in guter Näherung festgelegt werden, dass im Amplitudengang oberhalb der Grenzfrequenz f$_g$ keine nennenswerte Anregung stattfindet. Die *Pulsdauer t$_i$ ist gleich 2T$_i$ und die Grenzfrequenz $f_g = \dfrac{2}{T_i}$ ist.

Folgen nun mehrere Strompulse der gleichen Signalform mit einer unterschiedlichen Phasenlage aufeinander, so ändert sich die Einhüllende, die dem Frequenzspektrum eines Einfachpulses entspricht, nicht (vgl. Figur 4). Das Frequenzspektrum eines solchen Mehrfachpulses weist, im Gegensatz zum Frequenzspektrum des Einfachpulses, jedoch mehrere Nullstellen auf, die aufgrund der Phasendifferenz der Einzelpulse entstehen. Diese Nullstellen liegen bei den Frequenzen $\dfrac{3}{2T_i}$, $\dfrac{5}{2T_i}$, $\dfrac{7}{2T_i}$ usw.

Durch geeignete Wahl dieser Phasendifferenz können nun diese Nullpunkte so gelegt werden, dass sie bei den Resonanzfrequenzen f$_R$ des piezoelektrischen Aktors P oder deren Oberwellen liegen. Auch können hier Resonanzfrequenzen f$_R$ des Gesamtsystems berücksichtigt werden.

Diese variablen Nullstellen ergeben sich auch aus der Phasendifferenz des Ansteuersignals, also aus dem zeitlichen Abstand der Einzelpulse zueinander. Der piezoelektrische Aktor P kann folglich so angesteuert werden, dass beispielsweise die Bestromungsdauer t$_i$ und der zeitliche Abstand t$_d$ zwischen den Pulsen nur so wählbar sind, dass die Nullstellen des Frequenzspektrums wieder bei den Resonanzfrequenzen f$_R$ des Systems liegen. Zum einen können die festen Nullstellen, die durch Signalform und Pulsdauer festgelegt werden, so gewählt werden, dass die Nullstellen exakt bei den Resonanzfrequenzen f$_R$ des Injektors und/ oder Systems oder deren Oberwellen liegen. Die variablen Nullstellen, die sich durch die unterschiedlichen Ansteuerzeiten ergeben (Zeitliche Lage der Pulse) ergeben, können so arbeitspunktabhängig und kennfeldgesteuert optimiert werden, dass die Einspritzdauer t$_i$ und Abstände zwischen Lade- und Entladepuls t$_d$ beispielsweise nur in einem vorbestimmten Raster eingestellt werden können.

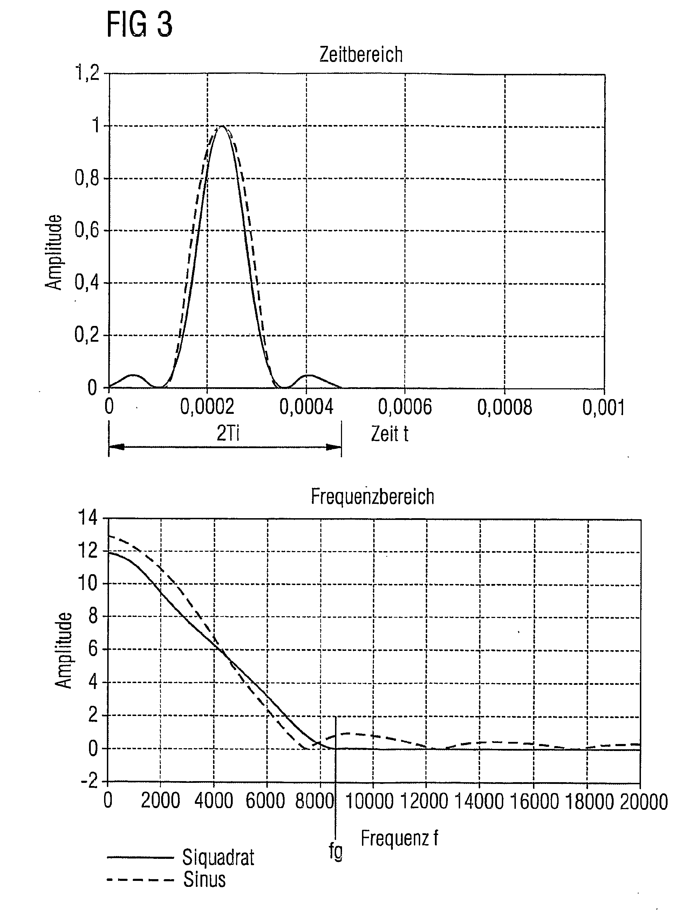

Figur 3 zeigt einen Vergleich eines sinusförmigen Ansteuerstroms I$_{ST}$ mit einem Si$^2$-förmigen, wie er in Figur 3 dargestellt ist, im Zeit- und im Frequenzbereich. In der Darstellung des Amplitudenverlaufs im Frequenzbereich ist deutlich zu erkennen, dass die Amplitude bei dem Si$^2$-förmigen Strom I$_{st}$ ab der Grenzfrequenz f$_g$ Null ist, wohingegen die Amplitude des sinusförmigen Stroms noch ca. 10% des Maximums beträgt. Die Grenzfrequenz liegt in diesem Ausführungsbeispiel bei etwa 8500 Hz.

In Figur 4 ist der Energieanteil des Ansteuerstroms I$_{ST}$ ist hier als Funktion der Frequenz für einen Einfach-, einen Zweifach- und einen Vierfachpuls im Frequenzbereich dargestellt. In dem hier dargestellten Beispiel liegt die Grenzfrequenz bei ca. 7500 Hz. In dieser Darstellung sind auch die Nullstellen des Frequenzspektrums eines Zwei- oder Vierfachpulses deutlich zu erkennen (bei einem Zweifachpuls: f = 1/t$_d$).

Da zur Reduktion der Schallemissionen und der hochfrequenten Anteile lediglich die Stromform, die zur Ansteuerung des piezoelektrischen Aktors P dient, angepasst wird, sind keine mechanischen oder konstruktiven Änderung am System selbst erforderlich. Das Verfahren kann somit sowohl zusätzlich zu mechanischen Schalldämmungsmaßnahmen, als auch bei bereits bestehenden Systemen eingesetzt werden.

Die Schallemissionen nehmen mit fallender Grenzfrequenz f$_g$ ab. Jedoch nimmt dann aber auch die Stellgeschwindigkeit des Aktors P ab. Somit muss ein Kompromiss zwischen akustischem Verhalten und der benötigten Stellgeschwindigkeit gefunden werden. Bei einer Verwendung des Aktors P als Stellglied in einem Einspritzventil wird hier eine Grenzfrequenz f$_g$ im Bereich von 5000 Hz bis 10000 Hz verwendet. Die Grenzfrequenz f$_g$ hängt jedoch von der Anwendung, in der der Aktor P eingesetzt wird, ab.

## Patentansprüche

1. Verfahren zum Ansteuern eines piezoelektrischen Aktors, das die folgenden Verfahrensschritte aufweist:

   - Erzeugen einer vorbestimmten Signalform für einen Ansteuerstrom (I$_{ST}$) durch einen Signalgenerator ($\mu$C, S),
   - Erzeugen des Ansteuerstroms (I$_{ST}$) aus der vorbestimmten Signalform durch eine Ansteuereinheit (D/A, AE),
   - Laden und/ oder Entladen des piezoelektrischen Aktors (P) durch den Ansteuerstrom (I$_{ST}$),

   wobei der Ansteuerstrom (I$_{ST}$) so ausgebildet ist, dass in einem Frequenzgang des Ansteuerstroms (I$_{ST}$) 99% der Amplitudenanteile unterhalb einer vorgegebenen Grenzfrequenz (f$_g$) liegen, und
   wobei der Amplitudenbetrag des Ansteuerstroms (I$_{ST}$) in Abhängigkeit von der Frequenz bei den Resonanzfrequenzen (f$_R$) des piezoelektrischen Aktors (P) Minima aufweist.

**2.** Verfahren nach Anspruch 1, **dadurch gekennzeichnet, dass** die Grenzfrequenz ($f_g$) zwischen 5000Hz und 10000Hz, vorzugsweise etwa bei 7500Hz liegt.

**3.** Verfahren nach einem der vorhergehenden Ansprüche, **dadurch gekennzeichnet, dass** die Signalform des Ansteuerstroms ($I_{ST}$) zum Laden und/oder Entladen so erzeugt wird, dass Lade- und Entladezeitdauern ($t_D$) und zeitliche Abstände ($t_d$) zwischen dem Laden und Entladen in vorbestimmten Zeitrastern einstellbar sind.

**4.** Vorrichtung zum Ansteuern eines piezoelektrischen Aktors, die die folgenden Bauelemente aufweist:

- einen Signalgenerator ($\mu$C, S), der eine vorbestimmte Signalform für einen Ansteuerstrom ($I_{ST}$) des piezoelektrischen Aktors (P) erzeugt,
- eine Ansteuereinheit (D/A, AE), die mit dem Signalgenerator und dem piezoelektrischen Aktor (P) elektrisch verbunden ist und einen Ansteuerstrom ($I_{ST}$) aus der Signalform erzeugt,

wobei der Ansteuerstrom ($I_{ST}$) des Aktors (P) so ausgeprägt ist, dass im Frequenzgang des Ansteuerstroms ($I_{ST}$) 99% der Anteile unterhalb einer vorgegebenen Grenzfrequenz ($f_g$) liegen, und
wobei der Amplitudenbetrag des Ansteuerstroms ($I_{ST}$) in Abhängigkeit von der Frequenz bei den Resonanzfrequenzen ($f_R$) des piezoelektrischen Aktors (P) Minima aufweist.

## Claims

**1.** Method for triggering a piezoelectric actuator, having the following method steps:

- generating a predetermined signal form for a trigger current ($I_{ST}$) by means of a signal generator ($\mu$C, S),
- generating the trigger current ($I_{ST}$) from the predetermined signal form by means of a trigger unit (D/A, AE),
- charging and/or discharging the piezoelectric actuator (P) by means of the trigger current ($I_{ST}$),

with the trigger current ($I_{ST}$) being configured in such a manner that in a frequency response of the trigger current ($I_{ST}$) 99% of the amplitude elements are below a predetermined limit frequency ($f_g$) and
with the amplitude modulus of the trigger current ($I_{ST}$) having minima as a function of frequency at the resonance frequencies ($f_R$) of the piezoelectric actuator (P).

**2.** Method according to claim 1, **characterised in that** the limit frequency ($f_g$) is between 5,000 Hz and 10,000 Hz, preferably around 7,500 Hz.

**3.** Method according to one of the preceding claims, **characterised in that** the signal form of the trigger current ($I_{ST}$) for charging and/or discharging is generated in such a manner that charging and discharging periods ($t_D$) and time intervals ($t_d$) between charging and discharging can be set in predetermined time frames.

**4.** Device for triggering a piezoelectric actuator, having the following components:

- a signal generator ($\mu$C, S), which generates a predetermined signal form for a trigger current ($I_{ST}$) of the piezoelectric actuator (P),
- a trigger unit (D/A, AE), which is connected electrically to the signal generator and the piezoelectric actuator (P) and generates a trigger current ($I_{ST}$) from the signal form,

with the trigger current ($I_{ST}$) of the actuator (P) being expressed in such a manner that in the frequency response of the trigger current ($I_{ST}$) 99% of the elements are below a predetermined limit frequency ($f_g$) and
with the amplitude modulus of the trigger current ($I_{ST}$) having minima as a function of frequency at the resonance frequencies ($f_R$) of the piezoelectric actuator (P).

## Revendications

**1.** Procédé de pilotage d'un actionneur piézo-électrique, qui présente les étapes suivantes :

- génération d'une forme de signal prédéfinie pour un courant de pilotage ($I_{ST}$) au moyen d'un générateur de

signaux ($\mu$C, S),

- génération du courant de pilotage ($I_{ST}$) à partir de la forme de signal prédéfinie au moyen d'une unité de pilotage (N/A, AE),
- charge et/ou décharge de l'actionneur piézo-électrique (P) au moyen du courant de pilotage ($I_{ST}$),

le courant de pilotage ($I_{ST}$) étant formé de telle sorte que, dans une réponse en fréquence du courant de pilotage ($I_{ST}$), 99 % des valeurs d'amplitude se trouvent en dessous d'une fréquence limite prédéfinie ($f_g$), et
la somme des amplitudes du courant de pilotage ($I_{ST}$) présentant des minima en fonction de la fréquence, pour les fréquences de résonance ($f_R$) de l'actionneur piézo-électrique (P).

2. Procédé selon la revendication 1,
**caractérisé en ce que**
la fréquence limite ($f_g$) est comprise entre 5 000 Hz et 10 000 Hz, et est de préférence à environ 7 500 Hz.

3. Procédé selon l'une des revendications précédentes,
**caractérisé en ce que**
la forme du signal du courant de pilotage ($I_{ST}$) pour la charge et/ou la décharge est générée de manière à pouvoir régler dans des schémas temporels prédéfinis les durées de charge et de décharge ($t_D$) et les intervalles dans le temps ($t_d$) entre la charge et la décharge.

4. Dispositif de pilotage d'un actionneur piézo-électrique, qui présente les composants suivants :

- un générateur de signaux ($\mu$C, S), qui génère une forme de signal prédéfinie pour un courant de pilotage ($I_{ST}$) de l'actionneur piézo-électrique (P),
- une unité de pilotage (N/A, AE), qui est reliée électriquement au générateur de signaux et à l'actionneur piézo-électrique (P) et génère un courant de pilotage ($I_{ST}$) à partir de la forme du signal,

le courant de pilotage ($I_{ST}$) de l'actionneur (P) étant développé de telle sorte que, dans la réponse en fréquence du courant de pilotage ($I_{ST}$), 99 % des valeurs se trouvent en dessous d'une fréquence limite prédéfinie (fg), et
la somme des amplitudes du courant de pilotage ($I_{ST}$) présentant des minima en fonction de la fréquence, pour les fréquences de résonance ($f_R$) de l'actionneur piézolectrique (P).

# FIG 1

# FIG 4

——— Einfachpuls (Einhüllende)
—·—·— Zwei Pulse (pos. & neg.)
············ Vier Pulse

FIG 2

## FIG 3

**Zeitbereich**

**Frequenzbereich**

——— Siquadrat

– – – – Sinus

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19946965 A1
- DE 10143502 C1
- DE 19931235 A1
- DE 19958262 A1
- WO 0133061 A1